(19) Europäisches Patentamt / European Patent Office / Office européen des brevets

(11) **EP 4 394 393 B1**

(12) **EUROPEAN PATENT SPECIFICATION**

(45) Date of publication and mention
of the grant of the patent:
**22.10.2025 Bulletin 2025/43**

(21) Application number: **22217036.7**

(22) Date of filing: **28.12.2022**

(51) International Patent Classification (IPC):
$G01R\ 15/20^{(2006.01)}$ $G01R\ 19/00^{(2006.01)}$
$G01R\ 33/06^{(2006.01)}$

(52) Cooperative Patent Classification (CPC):
**G01R 33/0017; G01R 15/202; G01R 15/207;
G01R 19/0092; G01R 33/022;** G01R 33/0206;
G01R 33/072; G01R 33/077

(54) **CURRENT SENSING WITH CROSSTALK IMMUNUITY**

STROMERFASSUNG MIT ÜBERSPRECHUNGSIMMUNITÄT

DÉTECTION DE COURANT AVEC IMMUNITÉ CONTRE LA DIAPHONIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**03.07.2024 Bulletin 2024/27**

(73) Proprietor: **Melexis Technologies SA
2022 Bevaix (CH)**

(72) Inventors:
• **HOUIS, Simon
2022 Bevaix (CH)**
• **BOURY, Bruno
3980 Tessenderlo (BE)**
• **RACZ, Robert
2022 Bevaix (CH)**

(74) Representative: **Winger
Hundelgemsesteenweg 1116
9820 Merelbeke (BE)**

(56) References cited:
**US-A1- 2020 191 835    US-A1- 2021 293 901**

• **CROCUS TECHNOLOGY: "Reducing the
Influence of External Fields & Crosstalk for
Contactless Current Sensing", 1 January 2020
(2020-01-01), XP093047836, Retrieved from the
Internet <URL:https://crocus-technology.com/
wp-content/uploads/2020/02/
AN122-Reducing-Influence-of-External-Field
s-on-Magnetic-Sensors-Rev0.3.pdf> [retrieved
on 20230517]**
• **MSAED A. ET AL: "A Simple and Accurate
Magnetic Gradient Sensor Configuration
Dedicated to Electrical Currents Measurements",
SENSOR LETTERS, vol. 7, no. 3, 1 June 2009
(2009-06-01), US, pages 497 - 502, XP093047197,
ISSN: 1546-198X, DOI: 10.1166/sl.2009.1096**

## Description

### Field of the invention

The invention relates to the field of current sensors. More specifically it relates to current sensing by measuring magnetic fields caused by the current, including compensation of crosstalk components of the magnetic field.

### Background of the invention

Current systems including a plurality of conductors usually require accurate currents through these conductors. Such is the case of multiphase current systems (e.g. electric motors and such). The measurement of these currents is traditionally done by measuring magnetic fields induced by the currents through the conductors. Magnetic sensors are used in contactless magnetic sensing. The current is calculated from the measured magnetic field.

However, the magnetic sensor measures the field at a given position, and the magnetic field at that position is influenced not only by the intended conductor, but also by parasitic fields, stray fields and such. One critical influence is crosstalk, which is the influence of magnetic fields induced by nearby conductors other than the intended conductor carrying the measured current. Gradiometric and common-mode magnetic sensing are affected by this source of error. While crosstalk can be reduced by physically separating the conductors, the separation has practical limits since current systems need to be compact.

The effect is usually compensated by the microcontroller using the information of the current, for example using a crosstalk error matrix system.

It would be desirable to provide a reduction of the parasitic influence to acceptable levels, without incurring in large computational costs. Document US 2020/191835 A1 discloses a current sensor comprising a magnetic sensor for sensing a component of the magnetic field at two different locations and determining a current based on a weighted difference of the two measured values.

### Summary of the invention

It is an object of embodiments of the present invention to provide a current sensor and sensing system in accordance with the appended claims, with reduced crosstalk from contributions of neighbouring sources of magnetic field.

In an aspect, the present invention provides a current sensor for sensing the current through a first conductor or target conductor, of a plurality of conductors, as defined in claim 1.

It is an advantage of embodiments of the present invention that the current measured by a single magnetic-based current sensor can have the crosstalk contribution reduced, without the need of additional signals from other sensors. For example, the coefficient is chosen relative to the distance between the sensor and at least one conductor other than the target conductor to be measured, i.e. other than the first conductor.

In some embodiments of the present invention, the processor is programmed with coefficients chosen in accordance with the distance between the magnetic sensor and the first conductor.

It is an advantage of embodiments of the present invention that the coefficient only depends on the air gap.

In some embodiments of the present invention, the coefficient is chosen in accordance with the distance, in a direction perpendicular to the distance between the magnetic sensor and the first conductor, between the magnetic sensor and a further conductor different from the first.

It is an advantage of embodiments of the present invention that the gain can take into account the disposition of the conductors.

The magnetic sensor may comprise a sensing element to sense the magnetic field component in a first direction and a sensing element to sense the magnetic field component in a second direction different from the first.

It is an advantage of embodiments of the present invention that gradient sensing, sensing of a field component, or a combination of both can be easily applied.

In some embodiments of the present invention, of the magnetic sensors comprises at least two magnetic sensing elements for measuring a gradient or a differential field in one direction. It is an advantage of embodiments of the present invention that the gradient in a direction of the magnetic field can be easily provided.

In some embodiments of the present invention, the at least one magnetic sensor and the processor are integrated in a single package, e.g. in a single chip.

It is an advantage of embodiments of the present invention that a very compact current sensor, including signal processing capabilities, and optionally also including integrated magnetic concentrators, can be provided, for measuring the current through a conductor.

In some embodiments of the present invention, the at least one magnetic sensor comprises a Hall effect sensor.

In an aspect, the present invention provides a current sensing system comprising a plurality of current conductors. Each conductor comprises at least one current sensor in accordance with embodiments of the first aspect, each sensor for sensing the current through each respective conductor, and for reducing the contribution of a parasitic magnetic field generated by the neighbouring conductors of the plurality.

It is an advantage of embodiments of the present invention that a device can be equipped with an accurate current monitoring sensing with a reduced cross talk. It is an advantage that the current through each of a plurality of conductors in the device can be monitored.

In some embodiments of the present invention, the coefficient of each sensor is a single coefficient optimized to minimize the cross talk of each respective conductor with respect to the other conductors.

It is an advantage of embodiments of the present invention that the same gain can be used to compensate any cross-talk field, simplifying processor programming, calibration and installation.

It is an advantage of embodiments of the present invention that the gain can be tailored for each conductor thus obtaining a very accurate current measurement with low cross talk, including asymmetrical systems.

In some embodiments of the present invention, the current sensor is positioned along a portion of the conductor, wherein said portion is magnetically shielded.

It is an advantage of embodiments of the present invention that the immunity to stray fields is increased. It is a further advantage that the sensing system is stable over mechanical tolerances.

In an aspect, the present invention provides a method of reducing cross talk of a current sensor for measuring current through a target conductor, according to claim 10.

It is an advantage of embodiments of the present invention that the cross talk from e.g. other conductors in a device can be compensated.

In some embodiments of the present invention, the method further comprises providing a current sensor at a sensing position, wherein determining the first and second magnetic field parameters comprises measuring the first and second magnetic field parameters. It is an advantage of embodiments of the present invention that a current sensor can be calibrated.

In some embodiments of the present invention, the method further comprises determining the first and second magnetic field parameters for a predetermined current flowing through the conductor.

In some embodiments of the present invention, the first magnetic field parameter is the gradient of a first component in a direction between the conductor and the sensing position, where the gradient direction is perpendicular to the first component and also perpendicular to the current, and the second magnetic field parameter is the magnetic field component in a direction perpendicular to the first magnetic field component and also perpendicular to the current.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

**Brief description of the drawings**

FIG 1 is the top view of a sensor for detecting current through a conductor, where a nearby conductor also carries current.

FIG 2 is a cross section of the sensor in FIG 1 and a zoomed-in detail of the cross section of the sensor, showing different components of the sensor.

FIG 3 illustrates a schematic of two conductors through which current flows, with a current sensor on top of each. The magnetic field caused by the current over the target conductor is shown. The current sensor measures this field. However, a nearby non-target conductor nearby also causes a magnetic field, affecting the reading of the current sensor.

FIG 4 illustrates a schematic of two conductors as before. In this case, the figure shows the specific influence of a nearby conductor on differential sensing.

FIG 5 is a schematic top view of a current sensor including horizontal Hall plates for reading of a differential field, as well as horizontal Hall plates combined with MC, for providing readings of the magnetic field in horizontal and vertical directions.

FIG 6 is a schematic top view of a current sensor including horizontal Hall plates for reading of a differential field, as well as a vertical Hall plate for providing readings of the magnetic field in a horizontal direction.

FIG 7 is a schematic top view of a current sensor including horizontal Hall plates for reading of a differential field, two vertical Hall plates for reading a horizontal field, and a vertical Hall plate for reading a vertical field.

FIG 8 is the cross section of a system including three conductors with respective current sensors, which obtain the reading from measurements of the magnetic field.

FIG 9 is a top view of an asymmetric distribution of conductors with a current sensor on top of each conductor.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

## Detailed description of illustrative embodiments

The present invention will be described with respect to particular embodiments and with reference to certain drawings but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention relates to magnetic field sensing, in particular to current sensing by measuring magnetic field parameters, while at the same time having the possibility of reducing the influence of other undesired sources, for example reducing cross talk from nearby sources of magnetic field. These sources may be current conductors. The invention can be applied to current sensing of a bus bar in a device such as a motor, while current flows through bus bars other than the one being measured. However, the invention can be applied to other devices such as a transformer, etc. In embodiments of the present invention, reference will be made to bus bars as the conductors of a plurality in a device, however the present invention can be applied to any other type of conductor such as wires, cables, tracks, etc.

Current through a conductor induces a magnetic field which can be detected by a magnetic sensor. Since current and the magnetic field are related by induction, the current through the conductor can be obtained from the measured magnetic field. The magnetic sensor provides a signal representative of the magnetic field. For example, a signal indicative of the magnetic field can be representative of a derivative, e.g. gradient, of the magnetic field.

This method assumes that the only source of magnetic field is the current through the conductor. However, the contribution to the magnetic field from other sources is also part of the field measured, and in some cases the contribution is large enough that the obtained current is different from the actual current flowing through the tested conductor over an unacceptable limit. Currents in nearby conductors are a large source of this contribution.

Where in embodiments of the present invention reference is made to "cross-talk", or simply CT, reference is made to the contribution of currents from conductors other than the conductor being tested to the magnetic field being measured.

While typically CT is reduced by increasing the distance between conductors, when the conductors are part of a device, the possibilities are limited to the geometric and compactness needs of the device.

The present invention allows reducing the CT by measuring different field parameters, e.g. in different directions, and calculating the current based on the measurements, further including in the calculation at least one weight coefficient for correcting the measurement of the current. The weight coefficient G, or simply coefficient, is chosen to reduce the contribution of CT. The choice can be made theoretically, by simulations, empirically, etc. Once the coefficient is obtained, it can be directly implemented in a programmable processor.

The present invention allows reducing CT using the measurements from a single current sensor. The coefficient is only dependent of the geometry of the system including the sensor and the bus bars. In other words, the sensor can be reprogrammed for different devices only taking into account the relative position of their elements.

In some embodiments, for example, the coefficient is only dependent on the distance between the magnetic sensor and the conductor. This means that the cross talk can be compensated without the need of physically separating the bus bars from each other, which allows reducing the distance between bus bars and even other conductors. Devices implementing the present invention can be more compact.

The CT can be cancelled by combining the contributions of the magnetic field using the following general relation:

$$\frac{d^i B_{x,z}}{dx^i} + G * \frac{d^j B_{x,z}}{dx^j} = 0$$

The coefficient G is the weight coefficient. The dependency of the CT with respect to the different parameters, for example in different directions, can be calculated, simulated, or by experimentation, e.g. by testing the influence of the external magnetic sources on the magnetic field parameters measured by the current sensor during calibration. Then, the weight coefficient G can be chosen to cancel the CT. In other words, G can be determined to comply with the above general relation.

The above equation can be resolved using the expressions of the magnetic field for two different directions. In the rest of the disclosure, the two different directions are two perpendicular directions. One of them is the Z direction, defined between the conductor being tested and the magnetic sensor, and the other direction, or X direction, is defined as being perpendicular to the direction of the current through the conductor and also perpendicular to the Z direction. The Z direction will be labelled as 'vertical direction' and the X direction the 'horizontal direction'. However, the magnetic field parameters may be measured in any two different directions of the field, not necessarily perpendicular.

The expressions of the magnetic field from a far conductor are the following:

$$B_x = CI * \frac{z}{(z^2 + x^2)} \qquad \frac{dB_x}{dx} = -CI * \frac{2zx}{(x^2 + z^2)^2} \qquad C = \frac{\mu_0}{2\pi}$$

$$B_z = -CI * \frac{x}{(z^2 + x^2)} \qquad \frac{dB_z}{dx} = CI * \frac{x^2 - z^2}{(x^2 + z^2)^2}$$

Further derivatives can be obtained (gradients in one direction, in this case the horizontal direction). In a multi-phase configuration, the expressions can be approximated with $x^2 > z^2$. Taking into account the magnetic field, the weight coefficient G can be obtained. Depending on the derivative degree (the values of i, j), said coefficient will be dependent of the distance between the sensor and the bus bar (1/z), also known as airgap, or it may be dependent of the distance in the horizontal between the sensor and the neighbouring bus bars (1/x, $1/x^2$), or dependent of both (e.g. $z/x^2$).

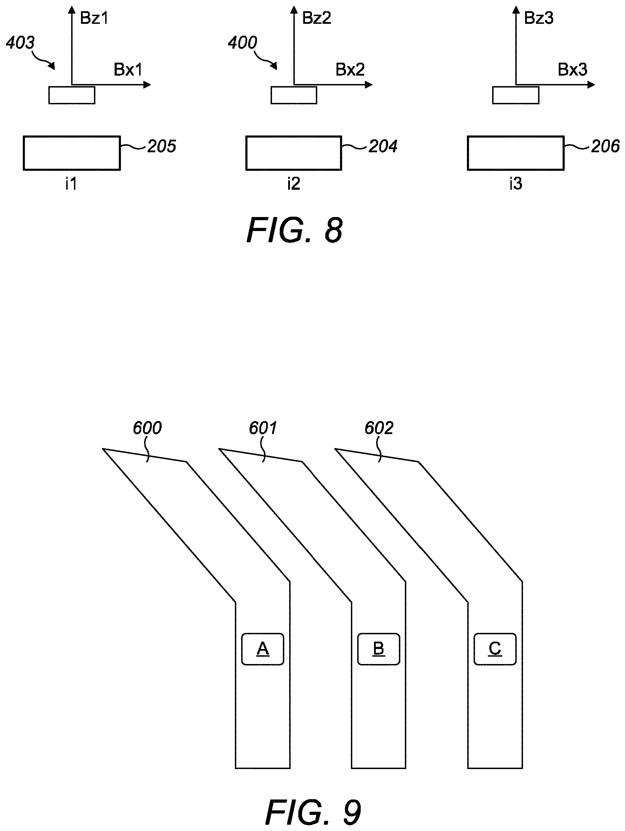

In other words, depending on the parameters being measured, the weight coefficient can be chosen as dependent of the distance between the sensor and the source of the magnetic field to be measured (the conductor under test), and/or of the distance between the sensor and the source of CT (neighbouring conductors) in the horizontal direction. In case of the magnetic field provided from a far conductor, using the expressions Bx, Bz, dBx/dx, dBz/dx obtained earlier, the value of the coefficient G is obtainable from the airgap (in the vertical direction z) and from the spacing between sensors (in the horizontal direction x). Moreover, since $x^2 > z^2$, the dependency of G on x is negligible, and the coefficient G depends only on the airgap (only on z). Thus, it is always possible to find a coefficient G which reduces CT so, once calibrated, the sensor will reject CT not only from one source or from one conductor, but from other sources (e.g. a third current i3 through a further conductor, see FIG 8 below for example) located at a different spacing.

In some embodiments of the present invention, more than two terms can be used to obtain a plurality of weight coefficients, allowing a finer tuning. The following expression can be used in general with pairs of terms separated by one derivative order:

$$\sum_0^n G_{1,k} \frac{d^{k+1}Bz}{dx^{k+1}} - G_{2,k} \frac{d^k Bx}{dx^k} = 0$$

The present invention is not limited thereto, for example both terms of a pair may have the same order of derivative (e.g. Bx-G Bz=0), or they may be separated by more than one order of derivative. However the present invention is not limited thereto, and the terms may be a component of the field and its derivative, e.g. gradient in a direction (e.g. Bz and dBz/dx)

In a first aspect, the present invention provides a sensor for measuring currents. The sensor includes a magnetic sensing system which provides signals corresponding to measurements of different magnetic field parameters of the magnetic field, for example for magnetic field parameters for different directions.

The sensing system may be adapted to provide measurement of magnetic field parameters in two different directions, for example two perpendicular directions. These parameters may include the magnetic field in two different directions, or the magnetic field in a first direction and the gradient of the magnetic field (or a differential field) in a different direction, or the gradient across one direction, of the field in two different directions. In some embodiments it may be adapted to provide measurement of a parameter in one direction and a derivative of the same parameter, e.g. gradient, e.g. a gradient in a different direction.

In some embodiments, the sensing system includes at least one magnetic sensor adapted to provide the required parameters. For example, the magnetic sensing system may include two sensors, one sensor for each parameter. For example, a first sensor may provide a signal representative of the magnetic field in a first direction, and a second sensor may provide a signal representative of the gradient in a first direction of the magnetic field in a second direction different (e.g. perpendicular) to the first direction.

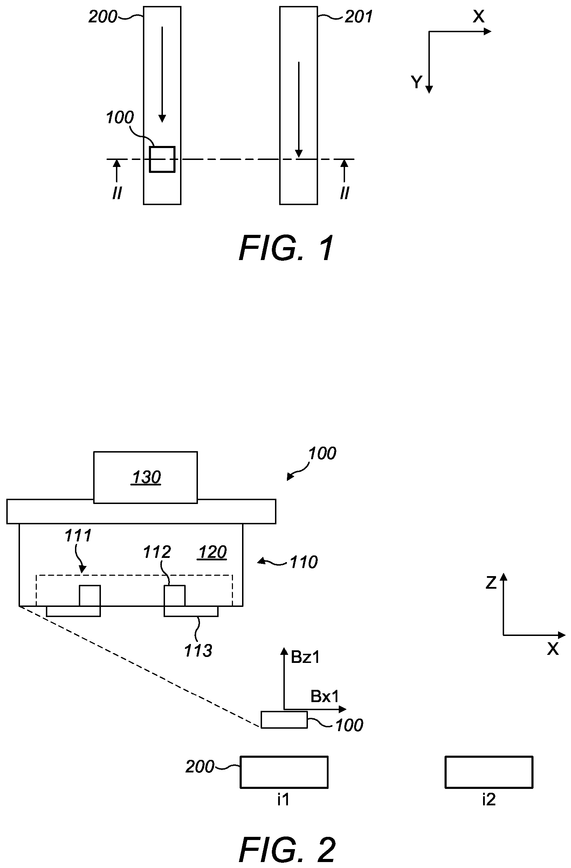

FIG 1 shows the top view of a current sensor 100 for measuring the current I1 through a conductor 200 such as a bus bar. The direction of the current I1 is indicated by the arrow in the bus bar. The magnetic field measured by the magnetic sensing system of the current sensor 100 includes CT contributions from nearby magnetic sources, such as currents through (at least one) neighbouring conductor 201, e.g. another bus bar.

G can be determined by simulation, calculation, or calibration. First, the current through the conductor 200 can be determined by the sensor 100 using the following equation:

$$I1 = A*Bx1 - G*dBz1$$

A can be a constant. The reading of the sensor may be influenced by the field generated by nearby conductors, e.g. a second conductor 201. Ideally, the current I1 measured by the sensor 100 is indicative of the current I1 in the conductor 200, and the sensor 100 rejects the contribution of the second conductor 201. In other words, if the conductor 200 does not conduct a current but the second conductor 201 does, the following relationship should be obtained:

$$I1 = A*Bx1 - G.dBz1 = 0$$

From this relationship, the value G is obtained (G= A*Bx1/dBz1) when a current is applied through the second conductor 201 and the current I1 through the first conductor is kept at a predetermined and characterized value, e.g. it may be kept as 0. As mentioned earlier, this can be done by calibration, for example by actually applying a current through the second conductor 201 and measuring the field parameters Bx1 and dBz1 with the sensor 100 in a real system. However, Bx1 and dBz1, and therefore G, can also be determined by simulation, calculation, or calibration.

The present invention provides that, in order to reduce or cancel cross talk, the value of the weight coefficient G is below 1.

FIG 2 shows cross section indicated by the line II-II in FIG 1. The current sensor 100 shows, in the zoomed area 110, a magnetic sensing system or magnetic sensor 111, which in this case includes two different magnetic sensing elements 112 in combination with integrated magnetic concentrators (IMC) 113 for detecting magnetic parameters in different directions. It is noted that there could be a single magnetic concentrator. In any case, use of magnetic concentrator is optional since other technologies can be used to detect magnetic field parameters in different directions (e.g. a combination of vertical and horizontal Hall plates).

The sensor may be at about 0.1 mm to 10 mm from its target conductor, e.g. between 0.5 mm and 3 mm.

The magnetic sensor 111 may be electronically coupled to a processor 130 for signal processing and output. The value of the weight can be programmed in the processor 130.

In some embodiments of the present invention, the magnetic sensing system is configured to provide two signals representative of the magnetic field components in two different, e.g. perpendicular, directions.

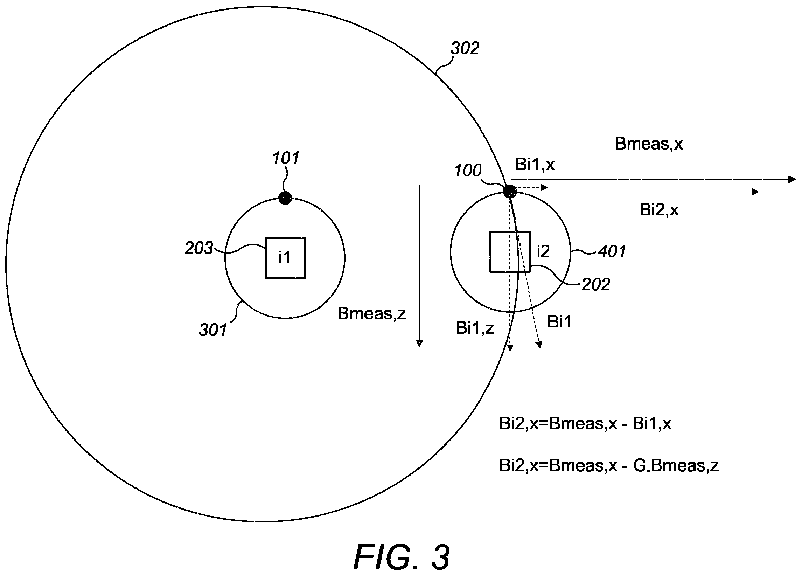

FIG 3 shows schematically two bus bars 202, 203 with a current sensor 100, 101 each. The current i1 through the first bus bar 203 generates a magnetic field represented by two circumferences 301, 302 centered on the bus bar 203. The small circumference 301 represents the magnetic field sensed by the respective sensor 101, while the larger circumference 302 represents the magnetic field affecting a different current sensor 100. This is the CT component affecting the current sensor 100. Hence, said sensor 100 detects a magnetic field formed by two components, a main component of the magnetic field induced by the intended current i2 of the conductor under test (represented by the small circumference 401 centred in the bus bar 202 under test), and the CT component from the magnetic field, represented by the circumference 302, generated by the first bus bar 203.

At the position of the sensor 100 on the right, the contribution of the main component in a first direction (in the horizontal direction X) is Bi 2,x (dashed arrow). The contribution of the CT component is Bi1, which is decomposed in two perpendicular directions Bi 1,x and Bi1,z (dotted arrow) corresponding to the horizontal and vertical directions as shown earlier.

The horizontal component of the magnetic field induced by the current i2 of the conductor 202 under test is Bi 2, x. The magnetic field detected by the sensor on the right is Bmeas, x and it is influenced by the horizontal direction of the CT component Bi1,x. Thus, it follows that:

$$B_{meas,X} = Bi_{2,X} + Bi_{1,X}$$

and hence

$$Bi_{2,X} = B_{meas,X} - Bi_{1,X}$$

Since the sensing system measures two directions of the field, the cross talk can be determined as follows:

$$Bi_{1X}\text{-}G\ B_{meas,Z} = 0, \text{ so } Bi_{1,X} = G\ B_{meas,Z}$$

This expression can be used for calibration of the weight coefficient G. For example, setting the current i2 to zero and turning the current i1 on, it is possible to provide G= Bmeas,X/ Bmeas,Z , where the values are those at sensor 100 facing the conductor 202 through which the current i2 should pass. This can also be done by simulation, calculation... The expression is a particular case of the general relation shown above, where i = j =0, and where each component Bx, Bz is measured in a different direction. Thus, the weight coefficient is chosen for reducing the CT contribution, the magnetic field induced by the tested current i2 can be obtained from the measurement:

$$Bi_{2,X} = B_{meas,X} - G\ B_{meas,Z}$$

From this expression, the current through the bus bar under test can be obtained.

The present invention can be applied to a gradiometric magnetic sensing system.

In some embodiments, the magnetic sensing system may include two sensors where a first sensor provides a signal representative of the magnetic field in a first direction, and a second sensor provides a signal representative of the gradient in a first direction of the magnetic field in a second direction different (e.g. perpendicular) to the first direction.

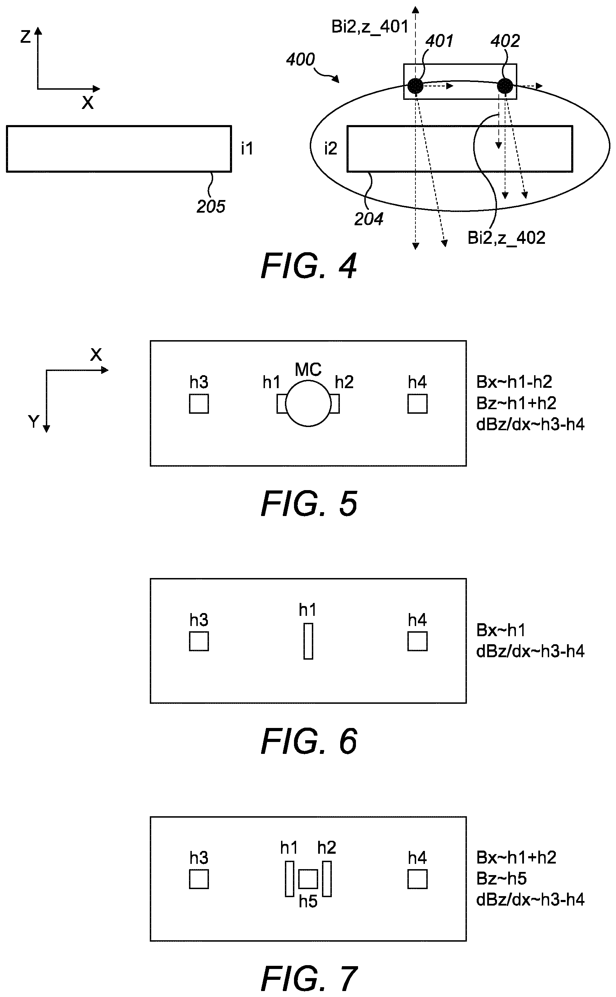

FIG 4 shows schematically a cross section of two bus bars 204, 205. Only the relevant current sensor 400 for the conductor 204 under test is shown. The current sensor 400 includes two sensing elements 401, 402 for obtaining the gradient of the vertical component of the field in the horizontal direction, in particular dBz/dx, which is obtained from the measurement of Bz in the first sensing element 401 and the measurement of Bz in the second sensing element 402 separated from each other in a horizontal direction X. These components are represented with the arrow labelled as Bi2,z_401 and Bi2,z_402. However, the measurement of the gradient includes additional components from the magnetic field Bi1 induced by the neighbouring bus bar 205. These components are shown with dashed arrows labelled as Bi1,z_401 and Bi1,z_402.

The general relation seen above, with i = j = 1, results in dBz/dx - GdBx/dx = 0

By symmetry, the current from the bus bar 204 under test does not generate a gradient of the field in the horizontal direction. In other words, the contribution of the field induced by the current i2 through the bus bar 204 under test in the horizontal direction at each sensing element cancels each other. Thus, the gradient of the magnetic field in the horizontal direction at the position of the sensor 400 is induced only by the neighbouring source of CT, namely the bus bar 205 which is not under test for the relevant sensor 400 and through which the current i1 flows, so dBx/dx = dBx_measured/dx. The CT field can be separated in a vertical component Bz and a horizontal component Bi1X, for each sensing element 401, 402 of the sensor 400. Thus, the measured dBx/dx is originated by CT.

The parasitic component of the gradient of Bz is the contribution of the field from the current through the bus bar 205 not under test, $dBi_{1,Z}$. Thus, the relationship becomes:

$$dBz\_parasitic/dx = G \ dBx\_measured/dx.$$

The corrected gradient of Bz in the horizontal direction (dBz/dx) is the magnetic field parameter induced by the current of the tested conductor. It can be obtained from the measurement of the gradient of Bz and additionally from the measured gradient of Bx which is exclusively a CT component. For the correction, the weight coefficient needs to be included:

$$dBz\_corrected = dBz\_measured - dBz\_parasitic = dBz\_measured-G.dBx\_measured$$

From the corrected gradient of the magnetic field in the vertical direction, it is possible to obtain the current inducing the field, which is the current flowing through the conductor 205 facing the sensor 400.

In a further embodiment, the first magnetic sensor is configured for detecting a parameter of the magnetic field in the vertical direction (Z) as defined earlier. The parameter is the gradient in the horizontal (X) direction. Thus, the first sensor provides a signal representative of $dB_Z/dx$, so the first sensor is a so-called a 'gradiometric sensor'.

The second magnetic sensor is configured for detecting the magnetic field itself, or magnetic induction, in the X direction defined as earlier. Thus, the second sensor provides a signal representative of the component Bx of the magnetic field vector in the X direction.

The coefficient G in this case can be obtained from the relation $dB_Z/dx+GB_X = 0$ as explained earlier. This expression is a particular case of the general relation shown above, where i = 1 and j = 0

Other gradiometric measurements can be provided. For example, the first sensor may provide a signal representative of a second order derivative, e.g. the Laplacian in a first direction of the magnetic field in a second direction, $d^2B_Z/dx^2$, while the second sensor may provide the gradient in a first direction of the magnetic field in the same first direction, $dB_X/dx$. In this case, the coefficient G in this case can be obtained from the relation $d^2B_Z/dx^2+G \ dB_X/dx = 0$ This expression is a particular case of the generalized expression shown above, where n = 1

The sensing system may be a gradiometric sensing system, a common mode field system, a sensing system for measuring the magnetic field on a direction (Bx, By, Bz), a hybrid system combining measurements of the magnetic field and the gradient of the field or the differential magnetic field, etc. It may include any suitable magnetic sensor, such as GMR, AMR, Hall sensors, etc. For example, the magnetic sensor for providing the gradient may include two sensing elements which provide the combined differential signal. The sensing system may also include magnetic concentrators for concentrating the magnetic field and directing it to the sensing elements. The magnetic sensing system includes signal output for further processing.

In some embodiments of the present invention, the field parameters provided by the magnetic sensing include more than two parameters of the magnetic field (e.g. the gradient, the magnetic field itself) in two different directions. For example, it may include the gradient $dB_Z/dX$ (in the horizontal direction X of the vertical component of the field Bz) of the magnetic field in the vertical direction Z, the magnetic field BX in the horizontal direction, and the magnetic field $B_Z$ in the vertical direction. Two weight coefficients, $G_X$ and $G_Z$, can be obtained by making the following equation equal to zero:

$$\frac{dB_z}{dx} + G_x B_x + G_z B_z = 0$$

For example, for embodiments of the sensor applied to a 3-phase system (such as the system shown in FIG 8), it can be considered for the first sensor 403 that no current flows through the conductor 205 facing the sensor, and a current i2 flows through a neighbouring conductor 204 and a further current i3 flows through another neighbouring conductor 206, so two equations for the system can be obtained and solved for Gx and Gz. As before, this can be done by measuring and calibrating, by calculation and/or by simulations.

Different magnetic sensors can be used in embodiments of the present invention, e.g. Hall plates, magnetoresistive elements, etc can be used. FIG 5 shows a first example of magnetic sensor including horizontal Hall plates h1, h2, which are sensitive to the magnetic field in the Z direction; the Bz component can be obtained from the summation of the signals of the horizontal Hall plates h1, h2. A magnetic concentrator MC is added so that the Bx component of the magnetic field can be obtained by subtraction. The sum results in the Bz component. Optionally, two Hall plates h3, h4 plates are added to extract dBz/dx.

FIG 6 shows an alternative magnetic sensor including a vertical Hall plate h1, which is sensitive in the horizontal (X) direction. The two plates h3, h4 on the sides provide signals whose difference provides dBz/dx.

FIG 7 shows an alternative magnetic sensor wherein the sensing elements in the central region combine a horizontal plate h5 and a vertical plate h1. Optionally, a second vertical plate h2 is added, for example for providing an additional signal. The horizontal field component Bx may be obtained from the signals of the two vertical plates (h1+h2), while the perpendicular field component Bz may be provided from the signal of the horizontal plate h5. Additional plates h3, h4 may provide the differential signal as in the previous figure.

Combinations of the signals (addition, etc) can be done by known means, e.g. different types of connections, summation, etc.

Going back to FIG 2 the current sensor in accordance with some embodiments of the present invention is shown in more detail. The current sensor 100 includes a processor 130 adapted to receive the signals from the sensors of the magnetic system, for providing the measurement signals adapted with the coefficient G. The processed signal is representative of the current, with reduced CT from outside sources. The processor may be implemented as an electronic circuit. In some embodiment, the current sensor 100 may include a semiconductor die 120 in which an integrated circuit is provided. In some embodiments of the present invention, the magnetic sensing system and the processor are integrated in the same semiconductor die, in a single chip (monolithically). However, the processor 130 may be a separate unit connected to the magnetic sensing system 111 as shown in FIG 2.

The die 120 may further integrate the sensing element or elements 112, e.g. further two Hall effect sensors 112 and IMC 113. Thus, a highly integrated current sensor for a single bus bar can provide a corrected signal representative of the current through the bus bar, without the need of signals from external sensors.

The processor can be programmed and, in some embodiments, reprogrammed, for example with new or updated value for one or more weight coefficients. This allows using the same current sensor with different configuration of the conductor or conductors, e.g. bus bars and different position of the sensor relative to said conductor or conductors.

In a second aspect, the present invention provides a system including a plurality of conductors. At least a sensor is configured for measuring the current through a conductor of the plurality. Preferably, the system includes one sensor per conductor. The sensor may be a sensor of the first aspect of the present invention.

In some embodiments, a plurality of current sensors is used, and the CT of each sensor is reduced by including one single value of the weight coefficient G for all the current sensors. This has the advantage that a single coefficient is required. Alternatively, the CT of each sensor is reduced by including a value tailored for each current sensor, for example with different weight coefficients. Although a weight coefficient needs to be obtained for each current sensor, the CT can be further reduced for the system. As mentioned earlier, the value of the coefficient G may be below 1.

FIG 8 shows a system including three coplanar conductors 204, 205 and one current sensor overlapping each conductor. The sensors 400, 403 are also laid out on the same plane, and at the same distance to the respective conductor. In this particular embodiment, the system is a symmetric system, so the CT of a first conductor on a sensor over a second conductor are the same as the CT of the second conductor on a sensor over the first conductor.

$$i1 = f(Bx1, Bz1), \quad i2 = f(Bx2, Bz2), \quad i3 = f(Bz3, Bx3)$$

e.g. i1=Gx*Bx1- Gz*Bz1, Gz is chosen such as to remove the cross talk coming from i2 and/or i3

Since the Gx is independent from x, the same gain can be used to compensate any CT field. Thus, the CT contribution Bx is always proportional to the CT contribution of the gradient parameter ∆Bz, being the gradient in the x direction, dBz/dx.

Table I shows the percentage of CT of three sensors A, B, C for measuring the current through three respective conductors A, B, C. For example, the column corresponding to Sensor A shows that there is the contribution of the current through the conductor A on the signals of the sensor A is 100% since that current is the intended target current to be measured. However, there is a 1.05% contribution from the current through the nearest neighbour conductor B, and a 0.28% contribution from the current through the next nearest neighbour conductor C. The rest of columns are interpreted in the same way. This is the result of a gradiometric measurement of the change, in the horizontal direction, of the vertical component of the field (Bz), thus dBz/dx. Since the system is symmetrical, the influence of the current A over the sensor C is the same as the influence of the current C over the sensor A, for instance.

Table I. CT influence in symmetrical system.

| CT in % | Sensor A | Sensor B | Sensor C |
|---|---|---|---|
| Current on A | 100.0 | 1.05 | 0.28 |
| Current on B | 1.05 | 100.0 | 1.05 |
| Current on C | 0.28 | 1.05 | 100.0 |

Table II includes in the calculation of the CT a second measurement of a field parameter in the horizontal direction (in this case Bx) and its corresponding weight coefficient Gx of 0.5. In this case, the CT from neighbouring conductors is sensibly reduced, in some case it is reduced down to a 14% (as in the case of, for example, the influence of the current on C over the sensor A).

Table II. CT correction, dBz/dx + GxBx

| CT in % | Sensor A | Sensor B | Sensor C |
|---|---|---|---|
| Current on A | 100.0 | 0.0 | 0.04 |
| Current on B | 0.0 | 100.0 | 0.0 |
| Current on C | 0.04 | 0.0 | 100.0 |

Table III shows the percentage of CT of three sensors A, B, C for measuring the current through three respective conductors A, B, C corresponding to the first, second and third conductors 600, 601, 602 respectively as explained before, however in this case the system is asymmetric. The asymmetry may stem from the distribution of the magnetic field with respect to the sensors. For example, if the airgap between each sensor and its respective conductor is not the same, or for example if the conductors are not straight in the vicinity of the sensors, or if the conductors are not in a same plane. For example, the bus bars 600 in the system may be bent close to the current sensors 601, as shown in FIG 9. Unlike the symmetric case, the influence of the current A through a first conductor 600 on the third sensor C is different from the influence of the current C through the third conductor 603 on the first sensor A (also for current B through the middle conductor 601 on sensor A and current A through the first conductor 600 on sensor B, the same mutatis mutandis for sensors B, C and the middle and right conductors 601, 602).

This is the result of a gradiometric measurement of the change, in the horizontal direction, of the vertical component of the field (Bz), thus dBz/dx.

Table III. CT influence in asymmetrical system.

| CT in % | Sensor A | Sensor B | Sensor C |
|---|---|---|---|
| Current on A | 100.0 | 2.22 | 0.56 |
| Current on B | 0.37 | 100.0 | 0.96 |
| Current on C | 0.06 | 0.58 | 100.0 |

Table IV shows the reduction of the CT, by including in the calculation the second measurement, as explained earlier. The weight coefficient may be the same for each sensor. For example, the processor of each sensor A to C may be programmed to implement the same weight coefficient, which is optimized for reducing CT.

Table IV. In this case the weight coefficient is Gx = -0.27 (for the three sensors)

| CT in % | Sensor A | Sensor B | Sensor C |
|---|---|---|---|
| Current on A | 100.0 | 0.5 | 0.13 |
| Current on B | 0.1 | 100.0 | 0.36 |
| Current on C | 0.02 | 0.15 | 100.0 |

Table V shows the reduction of the CT where the processor of each sensor is programmed with a different weight coefficient. The CT is further reduced as compared to the result using a single coefficient in most cases.

Table V. The coefficients used are $G^A_X$ = - 0.47 , $G^B_X$ = -0.36 , $G^C_X$ = -0.17

| CT in % | Sensor A | Sensor B | Sensor C |
|---|---|---|---|
| Current on A | 100.0 | 0.17 | 0.05 |
| Current on B | 0.0 | 100.0 | 0.02 |
| Current on C | 0.01 | 0.29 | 100.0 |

Table VI shows the CT reduction for the case where each sensor is corrected with three field parameters in different directions and two weight coefficients, as explained earlier:

$$\frac{dB_z}{dx} + G_x B_x + G_z B_z$$

Using Gz only is possible, while keeping Gx = 0. In this case, the signals obtained by the magnetic sensor are representative of the gradient (in x) of the perpendicular component, dBz/dx and the perpendicular component of the field Bz (thus, a weighted combination of the field and the gradient thereof). Three different values are used for Gz for each sensor, and the results are shown in Table VI. However, the CT is not reduced in every case.

Table VI. The coefficients used are $G^A_Z$ = 0.049 , $G^B_Z$ = -0.032 , $G^C_X$ = -0.02

| CT in % | Sensor A | Sensor B | Sensor C |
|---|---|---|---|
| Current on A | 100.0 | 0.07 | 0.09 |
| Current on B | 0.03 | 100.0 | 0.22 |
| Current on C | 0.07 | 0.9 | 100.0 |

Table VII shows the reduction of the CT when using the same weight coefficient for the horizontal component of the field (-0.22) and different coefficients for each sensor for the vertical component of the field.

Table VII. Coefficients used: $G_X$ = -0.22 and $G^A_Z$ = 0.027, $G^B_Z$ = -0.016 , $G^C_Z$ = 0.005

| CT in % | Sensor A | Sensor B | Sensor C |
|---|---|---|---|
| Current on A | 100.0 | 0.03 | 0.04 |
| Current on B | 0.02 | 100.0 | 0.06 |
| Current on C | 0.01 | 0.06 | 100.0 |

Table VIII shows the reduction of the CT where the processor of each sensor is configured to use different weight coefficient for the horizontal component of the field (-0.22) and different coefficients for the vertical component of the field. In this case, $G^A_X$ = - 0.027, $G^B_X$ = - 0.24 , $G^C_X$ = - 0.13 and $G^A_Z$ = 0.021, $G^B_Z$ = -0.015 , $G^C_Z$ = - 0.005

Table VIII. Each sensor is configured with different optimized weight coefficients

| CT in % | Sensor A | Sensor B | Sensor C |
|---|---|---|---|
| Current on A | 100.0 | 0.03 | 0.04 |
| Current on B | 0.02 | 100.0 | 0.06 |
| Current on C | 0.01 | 0.06 | 100.0 |

Different designs of conductors and distributions thereof lead to different readings. However, it is possible to obtain weight coefficients that reduce CT, even in asymmetric configurations.
In a further aspect, a method of calibrating a current sensor is provided. The method aims to a reduction of CT on a current sensor. The method entails determining the magnetic field at a position for positioning a current sensor, e.g. a contactless current sensor, e.g. a sensor for sensing magnetic field. The sensor may be placed so as to overlap the target conductor, for example close to the surface of the conductor, for example between 0.1 mm and 10 mm from the conductor, for example between 0.5 mm to 3 mm. Determining the magnetic field comprises further providing two different parameters of the magnetic field, for example two parameters in respective different directions, while an external active crosstalk source is present, thus a current flows through a conductor other than the target conductor. The parameters may alternatively comprise a component of the field in a predetermined direction (e.g. Bz) and a derivative of the component, e.g. a different direction (e.g. dBz/dx). The field may be optionally determined by assuming a known current flows through the conductor, or no current. These parameters can be combined to obtain a value representing the current through a conductor other than the target conductor. The method then comprises obtaining a weight coefficient such that, when applied to at least one of the parameters of the magnetic field, the parasitic contribution of conductors other than the target conductor is reduced. The value provided by the sensor, which is indicative of the current inducing the field when no active CT source is present, is substantially the same as the current inducing the field when an active CT source is present (e.g. when a current flows through a nearby conductor other than the target conductor). In some embodiments, the method further entails determining the magnetic field at the same position, while considering an active CT source generating a CT field. As before, a known current can be assumed to be flowing through the conductor, e.g. the same current as before

For example, a corrected parameter can be calculated as a linear combination of the determined parameters including the weight coefficient G. The corrected parameter of the field can be used to obtain the corrected current through the conductor. In embodiments of the present invention, the weight coefficient G is lower than 1.

The result may be the same, for example the same within a negligible margin, for example it may be close to the value when no other active source is present within 1%.

Determining the magnetic field can be done by design, for example by calculations, by simulations, etc. In some embodiments, determining the magnetic field may be done by providing a current sensor for measuring the current through a conductor, and measuring the magnetic field using a magnetic sensing system, further providing two parameters of the magnetic field in respective different directions. This measurement is performed while no external CT active source generates fields. Optionally, a known current may flow through the conductor with no external active CT source, e.g. no other nearby conductor carries current. The measurement is repeated while an external CT active source generates a CT field (optionally, a known current, e.g. the same current as in the previous step, may be flowing through the conductor being tested). For example, the external active source may be one or more conductors other than the one being under test.

The method comprises calculating a weight coefficient so the repeated measurement including a CT active source results in a measurement similar to the measurement with no CT active sources.

The present invention can be applied to DC battery monitoring against stray fields . It can be especially advantageous to reduce CT in 3-phase systems with several bus bars, such as electric motors, transformers, also in coreless motors, etc.

It is noted that the sensor provides two different parameters representative of the magnetic field components, which may be in different directions, the field being induced by a current. Thus, the processor can be programmed to combine two signals representative of the field, for example at different directions, for example a field component (e.g. Bx) and a derivative, e.g. gradient (e.g. dBz/dx), in a linear combination, in order to amplify the signal. The device features and combination of is the same as in the previous aspects of the present invention. However, the processor can be programmed so that the weight coefficient provides an increased signal to obtain the current inducing the field. For example the weight coefficient G may be set to 1 or higher. Thus, the resulting relation would be as before, however with G being 1. Although cross-talk would not be reduced by processing, the signal can increase. This also allows increasing signal to noise ratio. Such sensor could be used on its own, to provide current through a conductor, where cross talk is less important (due to shielding, large distance to other magnetic sources, etc.)

**Claims**

1. A current sensor (100) for sensing the current through a first conductor (200) of a plurality thereof, the sensor comprising:

   - at least one magnetic sensor (111) configured to provide a first signal representative of a magnetic field parameter comprising a magnetic field component in a first direction or a directional derivative of a component of the magnetic field, and configured to provide at least a second signal representative of a magnetic field parameter comprising a magnetic field component in a second direction different from the first direction or a directional derivative of a component of the magnetic field in the second direction,
   - a processor (130) configured for deriving a signal indicative of the current based on a linear combination of the first signal and the at least second signal, wherein one of the first signal or at least second signal is weighted by a coefficient, wherein the coefficient is a constant chosen in accordance with a distance, in at least the first or second direction, between the sensor and at least one conductor (200, 201) of the plurality to reduce a contribution of a parasitic magnetic field in the signal indicative of the current in the first conductor (200), where the parasitic magnetic field is generated by at least a further conductor (201).

2. The current sensor of the previous claim wherein the coefficient is chosen in accordance with the distance between the magnetic sensor (111) and the first conductor (200).

3. The current sensor of any one of the previous claims wherein the coefficient is chosen in accordance with the distance, in a direction perpendicular to the distance between the magnetic sensor and the first conductor, between the magnetic sensor and a further conductor different from the first.

4. The current sensor of any one of the previous claims wherein the magnetic sensor comprises at least two magnetic sensing elements for measuring a gradient or a differential field in one direction.

5. The current sensor of any one of the previous claims wherein the at least one magnetic sensor and the processor are integrated in a single chip.

6. The current sensor of any one of the previous claims wherein the at least one magnetic sensor comprises a Hall effect sensor.

7. A current sensing system comprising a plurality of current conductors, each conductor comprising at least one current sensor in accordance with any one of the previous claims, each sensor for sensing the current through each respective conductor, and for reducing the contribution of a parasitic magnetic field generated by the neighbouring conductors of the plurality.

8. The current sensing system of the previous claim wherein the coefficient of each sensor is a single coefficient optimized to minimize the cross talk of each respective conductor with respect to the other conductors.

9. The current sensing system of any one of claims 7 or 8 wherein the current sensor is positioned along a portion of the conductor, wherein said portion is magnetically shielded.

10. A method of reducing cross talk of a current sensor for measuring current through a target conductor, comprising

- determining a first signal representative of a magnetic field parameter comprising a magnetic field component in a first direction or a directional derivative of a component of a component of the magnetic field at a sensing position, and a second signal representative of a magnetic field parameter comprising a magnetic field component in a second direction different from the first or a directional derivative of a component of the magnetic field in said second direction, where the signals can be linearly combined to obtain a value representing the current through a conductor other than the target conductor, while current flows through a conductor other than the target conductor, and
- calculating a weight coefficient for which a combination of the obtained first and second signals, obtained while current flows in a conductor other than the target conductor, results in a reduced contribution of parasitic magnetic field from conductors other than the target conductor.

11. The method of the previous claim further comprises providing a current sensor at a sensing position, wherein determining the first and second signals comprises measuring the first and second magnetic field parameters.

12. The method of claims 10 or 11 further comprising determining the first and second signals for a predetermined current flowing through the conductor.

13. The method of any one of claims 10 to 12 wherein the first magnetic field parameter is the gradient of a first component in a direction between the conductor and the sensing position, where the gradient direction is perpendicular to the first component and also perpendicular to the current, and the second magnetic field parameter is the magnetic field component in a direction perpendicular to the first magnetic field component and also perpendicular to the current.

**Patentansprüche**

1. Ein Stromsensor (100) zum Erfassen des Stroms durch einen ersten Leiter (200) einer Vielzahl davon, wobei der Sensor umfasst:

   - zumindest einen Magnetsensor (111), welcher so konfiguriert ist, dass er ein erstes Signal bereitstellt, welches einen Magnetfeldparameter darstellt, welcher eine Magnetfeldkomponente in einer ersten Richtung oder eine Richtungsableitung einer Komponente des Magnetfelds umfasst, und welcher so konfiguriert ist, dass er zumindest ein zweites Signal bereitstellt, welches einen Magnetfeldparameter darstellt, welcher eine Magnetfeldkomponente in einer zweiten Richtung, welche sich von der ersten Richtung unterscheidet, oder eine Richtungsableitung einer Komponente des Magnetfelds in der zweiten Richtung umfasst,
   - einen Prozessor (130), welcher dazu konfiguriert ist, ein den Strom anzeigendes Signal basierend auf einer linearen Kombination des ersten Signals und des zumindest zweiten Signals abzuleiten, wobei eines von dem ersten Signal oder zumindest zweiten Signal durch einen Koeffizienten gewichtet wird, wobei der Koeffizient eine Konstante ist, welche in Übereinstimmung mit einem Abstand in zumindest der ersten oder zweiten Richtung zwischen dem Sensor und zumindest einem Leiter (200, 201) der Vielzahl gewählt wird, um einen Beitrag eines parasitären Magnetfelds in dem den Strom in dem ersten Leiter (200) anzeigenden Signal zu reduzieren, wenn das parasitäre Magnetfeld von zumindest einem weiteren Leiter (201) erzeugt wird.

2. Der Stromsensor nach dem vorstehenden Anspruch, wobei der Koeffizient in Übereinstimmung mit dem Abstand zwischen dem Magnetsensor (111) und dem ersten Leiter (200) gewählt wird.

3. Der Stromsensor nach einem der vorstehenden Ansprüche, wobei der Koeffizient in Übereinstimmung mit dem Abstand in einer Richtung senkrecht zu dem Abstand zwischen dem Magnetsensor und dem ersten Leiter zwischen dem Magnetsensor und einem weiteren Leiter, welcher sich von dem ersten unterscheidet, gewählt wird.

4. Der Stromsensor nach einem der vorstehenden Ansprüche, wobei der Magnetsensor zumindest zwei magnetische Erfassungselemente zum Messen eines Gradienten oder eines Differenzfelds in einer Richtung umfasst.

5. Der Stromsensor nach einem der vorstehenden Ansprüche, wobei der zumindest eine Magnetsensor und der Prozessor in einem einzelnen Chip integriert sind.

6. Der Stromsensor nach einem der vorstehenden Ansprüche, wobei der zumindest eine Magnetsensor einen Hall-Sensor umfasst.

7. Ein Stromerfassungssystem, umfassend eine Vielzahl von Stromleitern, wobei jeder Leiter zumindest einen Stromsensor in Übereinstimmung mit einem der vorstehenden Ansprüche umfasst, wobei jeder Sensor zum Erfassen des Stroms durch den jeweiligen Leiter und zum Reduzieren des Beitrags eines parasitären Magnetfelds dient, welches von den benachbarten Leitern der Vielzahl erzeugt wird.

8. Das Stromerfassungssystem nach dem vorstehenden Anspruch, wobei der Koeffizient jedes Sensors ein einzelner Koeffizient ist, welcher optimiert ist, um das Übersprechen jedes jeweiligen Leiters in Bezug auf die anderen Leiter zu minimieren.

9. Das Stromerfassungssystem nach einem der Ansprüche 7 oder 8, wobei der Stromsensor entlang eines Abschnitts des Leiters positioniert ist, wobei dieser Abschnitt magnetisch abgeschirmt ist.

10. Ein Verfahren zum Reduzieren von Übersprechen eines Stromsensors zum Messen von Strom durch einen Zielleiter, umfassend

    - Bestimmen eines ersten Signals, welches einen Magnetfeldparameter darstellt, welcher eine Magnetfeldkomponente in einer ersten Richtung oder eine Richtungsableitung einer Komponente einer Komponente des Magnetfelds an einer Erfassungsposition umfasst, und eines zweiten Signals, welches einen Magnetfeldparameter darstellt, welcher eine Magnetfeldkomponente in einer zweiten Richtung, welche sich von der ersten unterscheidet, oder eine Richtungsableitung einer Komponente des Magnetfelds in der zweiten Richtung umfasst, wobei die Signale linear kombiniert werden können, um einen Wert zu erhalten, welcher den Strom durch einen anderen Leiter als den Zielleiter darstellt, während Strom durch einen anderen Leiter als den Zielleiter fließt, und

- Berechnen eines Gewichtungskoeffizienten, bei welchem eine Kombination der erhaltenen ersten und zweiten Signale, welche erhalten werden, während Strom in einem anderen Leiter als dem Zielleiter fließt, zu einem reduzierten Beitrag des parasitären Magnetfelds von anderen Leitern als dem Zielleiter führt.

11. Das Verfahren nach dem vorstehenden Anspruch umfasst weiter Bereitstellen eines Stromsensors an einer Erfassungsposition, wobei Bestimmen des ersten und zweiten Signals Messen des ersten und zweiten Magnetfeldparameters umfasst.

12. Das Verfahren nach Ansprüchen 10 oder 11, weiter Bestimmen des ersten und zweiten Signals für einen vorbestimmten Strom umfassend, welcher durch den Leiter fließt.

13. Das Verfahren nach einem der Ansprüche 10 bis 12, wobei der erste Magnetfeldparameter der Gradient einer ersten Komponente in einer Richtung zwischen dem Leiter und der
Erfassungsposition ist, wobei die Gradientenrichtung senkrecht zu der ersten Komponente und auch senkrecht zu dem Strom verläuft, und der zweite Magnetfeldparameter die Magnetfeldkomponente in einer Richtung senkrecht zu der ersten Magnetfeldkomponente und auch senkrecht zu dem Strom ist.

**Revendications**

1. Un capteur de courant (100) pour détecter le courant à travers un premier conducteur (200) d'une pluralité de ceux-ci, ledit capteur comprenant :

   - au moins un capteur magnétique (111) configuré pour fournir un premier signal représentatif d'un paramètre de champ magnétique comprenant une composante de champ magnétique dans une première direction ou une dérivée directionnelle d'une composante du champ magnétique, et configuré pour fournir au moins un second signal représentatif d'un paramètre de champ magnétique comprenant une composante de champ magnétique dans une seconde direction différente de la première direction ou une dérivée directionnelle d'une composante du champ magnétique dans la seconde direction,
   - un processeur (130) configuré pour dériver un signal indicatif du courant basé sur une combinaison linéaire du premier signal et du ou des seconds signaux, dans lequel l'un des premiers signaux ou au moins un second signal est pondéré par un coefficient, dans lequel ledit coefficient est une constante choisie en fonction d'une distance, dans au moins la première ou la seconde direction, entre le capteur et au moins un conducteur (200, 201) de la pluralité pour réduire une contribution d'un champ magnétique parasite dans le signal indicatif du courant dans le premier conducteur (200), où le champ magnétique parasite est généré par au moins un autre conducteur (201).

2. Le capteur de courant de la revendication précédente dans lequel le coefficient est choisi en fonction de la distance entre le capteur magnétique (111) et le premier conducteur (200).

3. Le capteur de courant de l'une quelconque des revendications précédentes dans lequel le coefficient est choisi en fonction de la distance, dans une direction perpendiculaire à la distance entre le capteur magnétique et le premier conducteur, entre le capteur magnétique et un autre conducteur différent du premier.

4. Le capteur de courant de l'une quelconque des revendications précédentes dans lequel le capteur magnétique comprend au moins deux éléments de détection magnétique pour mesurer un gradient ou un champ différentiel dans une direction.

5. Le capteur de courant de l'une quelconque des revendications précédentes dans lequel le ou les capteurs magnétiques et le processeur sont intégrés dans une seule puce.

6. Le capteur de courant de l'une quelconque des revendications précédentes dans lequel le ou les capteurs magnétiques comprennent un capteur à effet Hall.

7. Un système de détection de courant comprenant une pluralité de conducteurs de courant, chaque conducteur comprenant au moins un capteur de courant conformément à l'une quelconque des revendications précédentes, chaque capteur servant à détecter le courant à travers chaque conducteur respectif, et à réduire la contribution d'un champ magnétique parasite généré par les conducteurs voisins de la pluralité.

**8.** Le système de détection de courant de la revendication précédente dans lequel le coefficient de chaque capteur est un seul coefficient optimisé pour minimiser la diaphonie de chaque conducteur respectif par rapport aux autres conducteurs.

**9.** Le système de détection de courant de l'une quelconque des revendications 7 ou 8 dans lequel le capteur de courant est positionné le long d'une portion du conducteur, ladite portion étant magnétiquement blindée.

**10.** Un procédé de réduction de la diaphonie d'un capteur de courant pour mesurer le courant à travers un conducteur cible, comprenant

- la détermination d'un premier signal représentatif d'un paramètre de champ magnétique comprenant une composante de champ magnétique dans une première direction ou une dérivée directionnelle d'une composante d'une composante du champ magnétique à une position de détection, et un second signal représentatif d'un paramètre de champ magnétique comprenant une composante de champ magnétique dans une seconde direction différente de la première ou une dérivée directionnelle d'une composante du champ magnétique dans ladite seconde direction, où les signaux peuvent être combinés linéairement pour obtenir une valeur représentant le courant à travers un conducteur autre que le conducteur cible, tandis que le courant circule à travers un conducteur autre que le conducteur cible, et
- le calcul d'un coefficient de pondération pour lequel une combinaison des premiers et seconds signaux obtenus, obtenue tandis que le courant circule dans un conducteur autre que le conducteur cible, entraîne une contribution réduite du champ magnétique parasite provenant de conducteurs autres que le conducteur cible.

**11.** Le procédé de la revendication précédente comprend en outre la fourniture d'un capteur de courant à une position de détection, dans lequel la détermination des premiers et seconds signaux comprend la mesure des premiers et seconds paramètres de champ magnétique.

**12.** Le procédé des revendications 10 ou 11 comprenant en outre la détermination des premiers et seconds signaux pour un courant prédéterminé circulant à travers le conducteur.

**13.** Le procédé de l'une quelconque des revendications 10 à 12 dans lequel le premier paramètre de champ magnétique est le gradient d'une première composante dans une direction entre le conducteur et la position de détection, où la direction du gradient est perpendiculaire à la première composante et également perpendiculaire au courant, et le second paramètre de champ magnétique est la composante de champ magnétique dans une direction perpendiculaire à la première composante de champ magnétique et également perpendiculaire au courant.

FIG. 1

FIG. 2

Bmeas,x

Bi2,x

Bi1,x

Bi1,z

Bi1

i2

*401*

*202*

*302*

*100*

Bmeas,z

*101*

i1

*203*

*301*

Bi2,x=Bmeas,x - Bi1,x

Bi2,x=Bmeas,x - G.Bmeas,z

*FIG. 3*

*FIG. 4*

Bx~h1-h2
Bz~h1+h2
dBz/dx~h3-h4

*FIG. 5*

Bx~h1
dBz/dx~h3-h4

*FIG. 6*

Bx~h1+h2
Bz~h5
dBz/dx~h3-h4

*FIG. 7*

*403*  Bz1  Bx1

i1  205

*400*  Bz2  Bx2

i2  204

Bz3  Bx3

i3  206

## FIG. 8

*600*  *601*  *602*

A  B  C

## FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2020191835 A1